# EUROPEAN PATENT APPLICATION

(11) **EP 3 962 045 A1**
(43) Date of publication of application: **02.03.2022**
(21) Application number: 20794749.0
(22) Date of filing: 25.02.2020
(51) Int. Cl.: H04M 1/02, H04N 5/225, G02F 1/1341

(54) **UNDER-SCREEN PHOTOGRAPHING ASSEMBLY, AND CORRESPONDING ORGANIC LIGHT-EMITTING DIODE DISPLAY SCREEN AND TERMINAL DEVICE**

(30) Priority: 25.04.2019 CN 201910339111
(71) Applicant: Ningbo Sunny Opotech Co., Ltd., Ningbo, Zhejiang 315400 (CN)
(72) Inventor: YUE, Zhipeng, Ningbo, Zhejiang 315400 (CN); WANG, Jun, Ningbo, Zhejiang 315400 (CN); DU, Jiawei, Ningbo, Zhejiang 315400 (CN)
(74) Representative: Dantz, Jan Henning
(86) International application number: PCT/CN2020/076566
(87) International publication number: WO 2020/215879

(57) **Abstract**

An organic light-emitting diode display screen (100) includes: a substrate (131), a buffer layer (132), a first electrode layer (133b), a pixel layer (133a), a second electrode layer (133c), a packaging layer (134), a polarizing layer (135), and a cover plate (136). The pixel layer (133a) includes a main display area (140) and a light transmissive area (139). The polarizing layer (135) has a polarizing layer through hole (135a). The part of the pixel layer (133a) located directly below the polarizing layer through hole (135a) forms the light transmissive layer (139), and the main display area (140) and the light transmissive area (139) are not separated using a packaging material. The packaging layer (134) packages the pixel layer (133a) by covering upper surfaces of the main display area (140) and the light transmissive area (139). There also provides a corresponding under-screen camera assembly and a terminal device. The present invention improves production efficiency and reduces production costs of an under-screen camera assemblies based on a "hole-punch screen", and helps reduce a size of a hole of the "hole-punch screens" while ensuring the amount of entered light of the under-screen camera modules.

## Description

### RELATED APPLICATION

This application requires the priority of the Chinese patent application number 201910339111.8 filed on April 25, 2019 having the title of "under-screen camera assembly, corresponding organic light-emitting diode display screen and terminal device", and the entire content of the application is incorporated here by reference..

### TECHNICAL FIELD

This application relates to optical imaging technology and display technology. In particular, this application relates to an under-screen camera assembly and corresponding organic light-emitting diode display screen and terminal device.

### BACKGROUND TECHNIQUE

In order to meet the needs of camera of customers, electronic terminals including mobile phones usually have camera functions. For this reason, the existing mobile phone terminals generally have front and rear camera modules, and the front camera modules are usually arranged on the same side of the display screen to satisfy the user's Selfie and other functions. However, as the screen-to-body ratio becomes larger and larger, higher and higher requirements are placed on the layout of the front camera.

In order to reduce the impact of the camera on the screen-to-body ratio and achieve a full screen, different manufacturers have developed a variety of solutions from different angles. One technical direction is to arrange the front camera module on the top frame of the mobile phone to form a notch or water drop screen that is close to the full screen. Another technical direction is: the use of telescopic camera modules to hide and use the camera. When shooting is required, the camera can be controlled to extend out of the housing of the mobile phone (or other electronic device) to take the picture; after the shooting is completed, the camera is retracted into the housing of the mobile phone (or other electronic device). However, the camera is prone to be impacted by an external force during the continuous expansion and contraction process and the camera is extended relative to the mobile phone (or other electronic device), which may cause damage to the front camera, and it is difficult to replace it.

In recent months, some manufacturers have introduced under-screen camera solutions, commonly known as "hole-punch screen" or "hole-dig screen". The technology is: punching through holes or blind holes in the display screen, and placing the front camera module at the through holes or behind the blind holes. This kind of technology can save the motor used to drive the camera to expand and contract, which helps to improve reliability of the product. However, under the existing technical conditions, the area of the "punched" or "dug" part of the display screen is relatively large (for example, the hole diameter of a circular hole is usually greater than 4mm), and this kind of digging will cause a negative impact on user experience.

In the field of display technology, an organic light-emitting diode display screen (i.e., an OLED screen, wherein OLED is the abbreviation of Organic Light-Emitting Diode, and organic light-emitting diode display screen is sometimes called an organic electro-luminescent display screen) can emit light without a backlight. And the OLED screen is transparent to a certain extent. However, unlike lens materials such as glass and resin, the OLED screen have complex microstructures inside. These microstructures includes, for example, a large number of light-emitting structures made on a substrate based on semiconductor technology and corresponding micro-circuit structures for controlling the light-emitting structures. The complex microstructure inside the screen causes the light transmittance of the OLED screen to be much lower than that of glass, resin and other lens materials. If the front camera module is arranged at the rear end of the existing OLED screen, the OLED screen (although it has a certain light transmittance) will still block the front camera module and cannot perform imaging.

In the existing "hole-punch screen" technology, the hole-punch scheme of the OLED screen is usually to punch through holes, so as to avoid insufficient light intake of the under-screen camera module cause by the occlusion of the OLED screen. However, punching through holes on the OLED screen requires many changes to the production process of the OLED screen, which increases the process difficulty of the OLED screen, which has an adverse effect on the yield and cost under mass production conditions. On the other hand, there is also a solution for punching holes for the backlight plate of a LCD screen in the prior art, that is, the blind hole screen solution. In this solution, only the backlight plate of the LCD screen can be penetrated. However, the thickness of the LCD screen itself is usually significantly larger than that of the OLED screen, which makes it difficult for terminal devices (such as mobile phones) equipped with under-screen camera modules to be thinner. Therefore, people may be more looking forward to an under-screen camera module solution based on the OLED screen. However, the structure of the OLED screen is completely different from that of the LCD screen. For example, there is no backlight plate in the OLED screen at all, so the hole punching scheme of the LCD screen cannot be directly applied to the OLED screen.

In summary, consumers are eager for a full-screen solution. However, in the prior art, whether it is a notch, a water drop screen, a "hole-punch screen", or a telescopic proactive solution, all have their own shortcomings. Therefore, in the current market, there is an urgent need for an under-screen camera solution with low process difficulty, which can reduce the size of the digging hole or even without digging the hole.

### SUMMARY OF THE INVENTION

The present invention aims to provide a solution that can overcome at least one of the drawbacks of the prior art.

According to one aspect of the present invention, there provides an organic light-emitting diode display screen, including: a substrate, a buffer layer, a first electrode layer, a pixel layer, a second electrode layer, a packaging layer, a polarizing layer and a cover plate; wherein the pixel layer includes a main display area and a light-transmitting area, and the polarizing layer has a polarizing layer through hole, a portion of the pixel layer directly below the polarizing layer through hole forms the light-transmitting area, and the main display area and the light-transmitting area are not separated using a packaging material, and the packaging layer packages the pixel layer by covering upper surfaces of the main display area and the light-transmitting area.

Wherein, An aperture of the polarizing layer through hole is 1 mm to 2.5 mm.

Wherein, the main display area includes a plurality of pixel light-emitting structures arranged in an array and a pixel defining structure filling gaps between the plurality of pixel light-emitting structures, and the light-transmitting area is formed by filling a light-transmitting material or a light-transmitting structure, so that a light transmittance of the light-transmitting area is greater than that of the main display area.

Wherein, the polarizing layer is bonded to the packaging layer by optical glue.

Wherein, the polarizing layer through hole is filled with the optical glue.

Wherein, the main display area and the light-transmitting area together form a continuous upper surface, and the packaging layer packages the pixel layer by covering the continuous upper surface.

Wherein, the main display area includes a plurality of pixel light-emitting structures arranged in an array and a pixel defining structure filling the gaps between the plurality of pixel light-emitting structures.

Wherein, each of the pixel light-emitting structures includes a hole layer, an electron layer, and a light-emitting material layer located between the hole layer and the electron layer, and the hole layer includes a hole injection layer and a hole transport layer, and the electron layer includes an electron transport layer and an electron injection layer.

Wherein, the substrate has a substrate through hole corresponding to the light-transmitting area.

Wherein, the substrate is provided with a positioning mark, and the positioning mark is used to align the camera module with the through hole during an assembly process.

Wherein, the light-transmitting area is formed by filling with optical glue.

Wherein, a manufacturing material of the light-transmitting area is the same as a filling material of the pixel defining structure, and the manufacturing material is a light-transmitting material.

Wherein, the light-transmitting area has a pixel light-emitting structure, and a pixel pitch of the light-transmitting area is greater than a pixel pitch of the main display area, so that the light transmittance of the light-transmitting area is greater than that of the main display area.

According to another aspect of the present application, there also provides an under-screen camera assembly, which includes: any of the organic light-emitting diode display screens described above; and a camera module, wherein an optical axis of the camera module is perpendicular to a surface of the organic light-emitting diode display screen, and the camera module is located at a rear end of the under-screen camera area.

Wherein, the first electrode layer and the second electrode layer are respectively located below and above the pixel layer, and the first electrode layer constitutes a diaphragm of the camera module.

Wherein, the packaging layer covers an upper surface of the second electrode layer.

Wherein, the substrate has a substrate through hole corresponding to the light-transmitting area, and a top end of the camera module extends into the substrate through hole and bears against a bottom surface of the buffer layer.

Wherein, the first electrode layer is a cathode layer, and the cathode layer has a cathode layer through hole to form an aperture of the diaphragm, and a thickness of the cathode layer achieves a thickness suitable for light shielding to form a light shielding portion of the diaphragm.

Wherein, the first electrode layer has a first through hole to form an aperture of the diaphragm, and the first through hole is filled with optical glue.

According to another aspect of the present application, there also provides a terminal device, which includes any of the above-mentioned under-screen camera assemblies.

Wherein, the camera module is used as a front camera module of the terminal device, and the organic light-emitting diode display screen is used as a display panel on the front of the terminal device.

Compared with the prior art, this application has at least one of the following technical effects:
1. The present application can reduce the process difficulty of the "hole-dig screen", so that production efficiency of the under-screen camera assembly based on the "hole-dig screen" is improved and production costs are reduced.
2. The present application can help reduce the size of a hole of the "hole-dig screen" while ensuring the amount of light entering the under-screen camera module, thereby improving the user experience. The size of the hole here refers to the size of a hole in the display screen that a user can observe from the front when a display device is turned on.
3. In some examples of the present application, the optical glue can be filled in a hole-digging places of one or more functional layers of the display device, so that a surface of each functional layer can be smooth under the premise of ensuring the light transmittance, and strength and reliability of the structure of the "hole-dig screen" can be improved. ".
4. In some examples of the present application, the height of the under-screen camera module (referring to the size in an optical axis direction) can be reduced by making the first electrode layer in the display device into the diaphragm, thereby helping to reduce the thickness of the terminal device. (e.g., mobile phone).
5. In some examples of the present application, the under-screen camera module can be closely attached to a bottom surface of the display device, thereby helping to increase the amount of light entering the under-screen camera module.
6. In some examples of the present application, the under-screen camera module can be closely attached to the bottom surface of the display device, which can reduce the difficulty of aligning the under-screen camera module and the "dug" screen together.
7. In some examples of the present application, a substrate (or referred to as the base layer) of the display device can be dug to help increase the amount of light entering the under-screen camera module.
8. In some examples of the present application, the substrate (or base layer) of the display device can be dug, and top of the under-screen camera module can directly bear against a buffer layer of the display device, thereby reducing the transmission distance of external light to the camera module, further increasing the amount of light entering the under-screen camera module.
9. In some examples of the present application, the light transmittance of the under-screen camera area can be increased by reducing the pixel density of the under-screen camera area, so that the screen can avoid an imaging light path of the camera module without punching a hole, so as to maintain the integrity of the display screen.
10. The under-screen camera assembly of the present application is particularly suitable for use in a smart phone, and the camera module in the under-screen camera assembly is particularly suitable for use as a front camera module of the smart phone.

### DESCRIPTION OF THE DRAWINGS

Exemplary examples are shown in the referenced drawings. The examples and drawings disclosed herein should be regarded as illustrative rather than restrictive.
Figure 1 shows a schematic cross-sectional view of an under-screen camera assembly according to an example of the present application;
Figure 2 shows a schematic top view of the organic light-emitting diode display screen in Figure 1;
Figure 3 shows a schematic cross-sectional view of a typical organic light-emitting diode display screen;
Figure 4 shows detailed structures of a pixel layer, a buffer layer and other surrounding functional layers in Figure 3;
Figure 5 shows a schematic cross-sectional view of an under-screen camera assembly according to an example of the present application;
Figure 6 shows a schematic cross-sectional view of an under-screen camera assembly according to another example of the present application;
Figure 7 shows a schematic cross-sectional view of an under-screen camera assembly according to yet another example of the present application;
Figure 8 shows a schematic cross-sectional view of an under-screen camera assembly in an example of the present application in which a light-transmitting area and a main display area adopt a same structure;
Figure 9 shows a schematic cross-sectional view of an under-screen camera assembly in another example of the present application in which a light-transmitting area and a main display area adopt a same structure;
Figure 10 shows a schematic cross-sectional view of a comparative example of an organic light-emitting diode display screen adopting a through-hole screen scheme;
Figure 11 shows a schematic diagram of a substrate of an OLED screen with a positioning mark.

### DETAIL DESCRIPTION OF THE INVENTION

In order to better understand the application, various aspects of the application will be described in more detail with reference to the accompanying drawings. It should be understood that these detailed descriptions are only descriptions of exemplary examples of the present application, and are not intended to limit the scope of the present application in any way. Throughout the specification, the same reference numerals refer to the same elements. The expression "and/or" includes any and all combinations of one or more of the associated listed items.

It should be noted that, in this specification, expressions such as first, second, etc. are only used to distinguish one feature from another feature, and do not represent any restriction on the feature. Therefore, without departing from the teachings of the present application, the first subject discussed below may also be referred to as the second subject.

In the drawings, the thickness, size, and shape of objects have been slightly exaggerated for ease of description. The drawings are only examples and are not drawn strictly to scale.

It should also be understood that, the terms "include", "including", "have", "comprise" and/or "comprising", when used in this specification, mean that the stated features, wholes, steps, operations, elements, and/or components exist, but it does not exclude the presence or addition of one or more other features, wholes, steps, operations, elements, components, and/or combinations thereof. In addition, when the expression "at least one of..." appears after a list of listed features, it modifies the entire listed feature instead of modifying an individual elements in the list. In addition, when describing the examples of the present application, the use of "may" means "one or more examples of the present application". And, the term "exemplary" is intended to refer to an example or illustration.

As used herein, the terms "substantially", "approximately", and similar terms are used as approximate terms, not as terms representing degree, and are intended to illustrate inherent deviations in measured or calculated values that will be recognized by those of ordinary skill in the art.

Unless otherwise defined, all terms (including technical terms and scientific terms) used herein have the same meanings as commonly understood by those of ordinary skill in the art to which this application belongs. It should also be understood that terms (such as those defined in commonly used dictionaries) should be interpreted as having meanings consistent with their meanings in the context of related technologies, and will not be interpreted in an idealized or excessively formal sense, unless this is clearly defined in this article.

It should be noted that the examples in the present application and the features in the examples can be combined with each other if there is no conflict. Hereinafter, the present application will be described in detail with reference to the drawings and in conjunction with the examples.

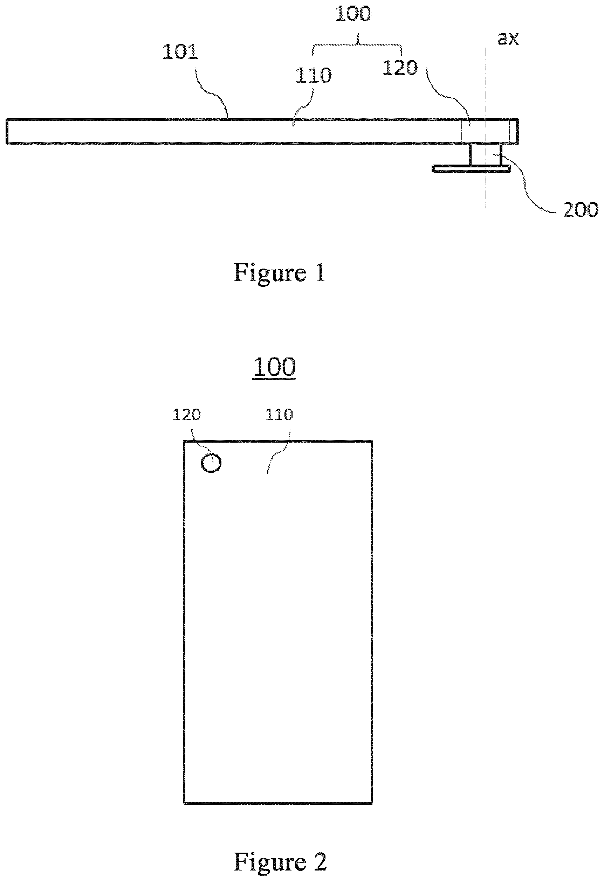

Figure 1 shows a schematic cross-sectional view of an under-screen camera assembly according to an example of the present application. Referring to Figure 1, the under-screen camera assembly includes an organic light-emitting diode display screen 100 (i.e., an OLED screen) and a camera module 200 located at a rear end of the organic light-emitting diode display screen 100. An optical axis ax of the camera module 200 is substantially perpendicular to a surface 101 of the organic light-emitting diode display screen 100. Here, the "rear end" refers to an end of an imaging optical path of the camera module 200 close to an image side. The camera module 200 is located at a rear end of an under-screen camera area 120 of the organic light-emitting diode display screen 100. Wherein, the under-screen camera area 120 is an area in the organic light-emitting diode display screen 100 that is adapted to the camera module 200. Further, Figure 2 shows a schematic top view of the organic light-emitting diode display screen in Figure 1. Referring to Figure 2, a display area of the organic light-emitting diode display screen includes the under-screen camera area 120 and a non-under-screen camera area 110. The under-screen camera area 120 may be circular, and its size may be adapted to the size of the camera module 200. The under-screen camera area 120 may be surrounded by the non-under-screen camera area 110.

In the present application, the organic light-emitting diode display screen 100 adopts a special structure design to construct the under-screen camera area 120. For ease of understanding, the structure of the organic light-emitting diode display screen will be briefly described below.

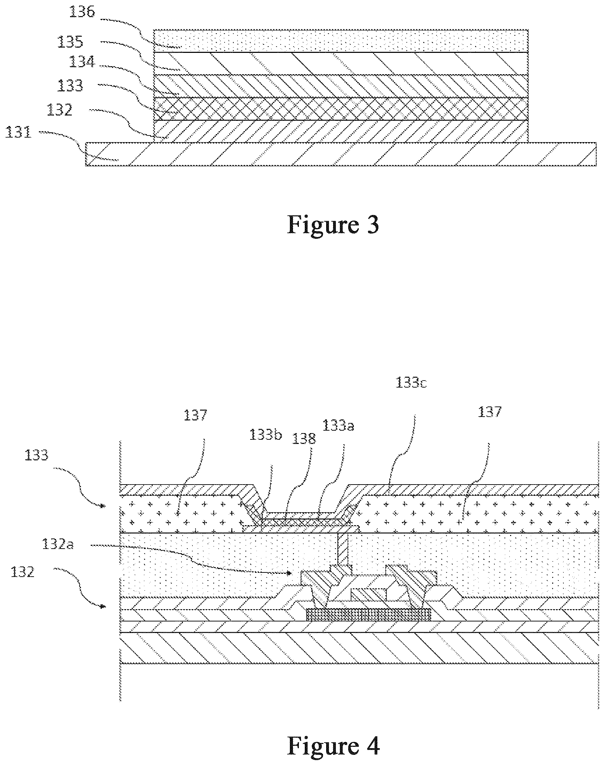

Figure 3 shows a schematic cross-sectional view of a typical organic light-emitting diode display screen. Referring to Figure 3, the organic light-emitting diode display screen 100 includes: a substrate 131, a buffer layer 132, a display layer 133 located above the buffer layer 132, and a packaging layer 134 covering the display layer 133, a polarizing layer 135 located above the packaging layer 134, and the cover plate 136 covering the polarizing layer 135. Wherein, the display layer 133 can be further divided into a first electrode layer, a pixel layer, and a second electrode layer.

Specifically, in the organic light-emitting diode display screen (i.e., an OLED screen), the substrate may be a glass cover plate, or may be made of glass or transparent plastic. Transparent plastics can be an organic material selected from a group consisting of: polyethersulfone (PES), polyacrylate (PAR), polyetherimide (PEI), polyethylene naphthalate (PEN), polyethylene terephthalate (PET), polyphenylene sulfide (PPS), polyallylate, polyimide, polycarbonate (PC), cellulose triacetate (TAC) and/or cellulose acetate propionate (CAP).

Further, Figure 4 shows detailed structures of the pixel layer, the buffer layer and other surrounding functional layers in Figure 3. Referring to Figure 4, in an example, the display layer 133 includes a first electrode 133b, a pixel layer 133a, and a second electrode 133c. The pixel layer 133a may include a plurality of pixel light-emitting structures 138 and a pixel defining structure 137 filling gaps between the plurality of pixel light-emitting structures 138. Further, the pixel light-emitting structure 138 may include an electron injection layer, an electron transport layer, a light-emitting material layer, a hole transport layer, and a hole injection layer. The first electrode 133b and the second electrode 133c may cover the electron injection layer and the hole injection layer, respectively. In this example, the first electrode 133b is a metal cathode, and the second electrode 133c is an anode. The anode can be at least one material selected from a group consisting of: indium tin oxide (ITO), indium zinc oxide (IZO), zinc oxide (ZnO), indium oxide (In2O3), oxide indium gallium (IGO) and aluminum oxide zinc (AZO). Pixel electrodes all need to cover a surface of the light-emitting material, and the anode is transparent, and the first electrode 133b can be silver or silver alloy, so that the cathode is not transparent (it can also be coated with a reflective film to make the cathode to be not transparent), therefore, all the light emitted by the light-emitting layer material is transmitted from the anode, and a drain electrode of a thin film transistor is connected to the first electrode 133b so as to be conducted to the pixel light-emitting structure, and a signal for driving light emission is transmitted to the display layer of the OLED screen.

Further, still referring to Figure 4, the buffer layer 132 may be used as a barrier layer for reducing or preventing diffusion of impurity ions into the display layer 133, and reducing or preventing external air or moisture from penetrating therethrough. The buffer layer 132 can also flatten a surface of the substrate. In addition, the buffer layer usually also includes a TFT driving layer. The TFT driving layer has a plurality of TFT units (i.e., thin film transistors 132a) corresponding to the pixel light-emitting structure to drive the pixel light-emitting structure to emit light or be turned off (sometimes it can also drive the pixel light-emitting structure to change brightness). The thin film transistor 132a may be formed on a body material of the buffer layer, and its source electrode or drain electrode is connected to the first electrode 133b of the display layer.

Further, in an example of the present application, the packaging layer (TFE) is a thin film packaging layer, which is located on the display layer. The thin film packaging layer can include an organic thin film and an inorganic thin film, or a plurality of organic films and inorganic films alternately stacked. A function of the thin film packaging layer is to prevent the display layer from being affected by external moisture or oxygen. Wherein, the inorganic film stably blocks external moisture and oxygen, while the organic film can absorb the stress on the inorganic film to give the inorganic film flexibility.

Further, in an example of the present application, the polarizing layer (POL) includes a polarizer and a quarter-wave plate, which are used to reduce reflection of natural light and improve the contrast of the display screen. Usually, the polarizing layer also includes a touch control layer (or called the touch layer).

The above is a brief description of a typical organic light-emitting diode display screen in combination with Figure 3 and Figure 4. In the following, in combonation with the examples, the organic light-emitting diode display screen that can be used for the under-screen camera assembly and constructs the under-screen camera area 120 will be described.

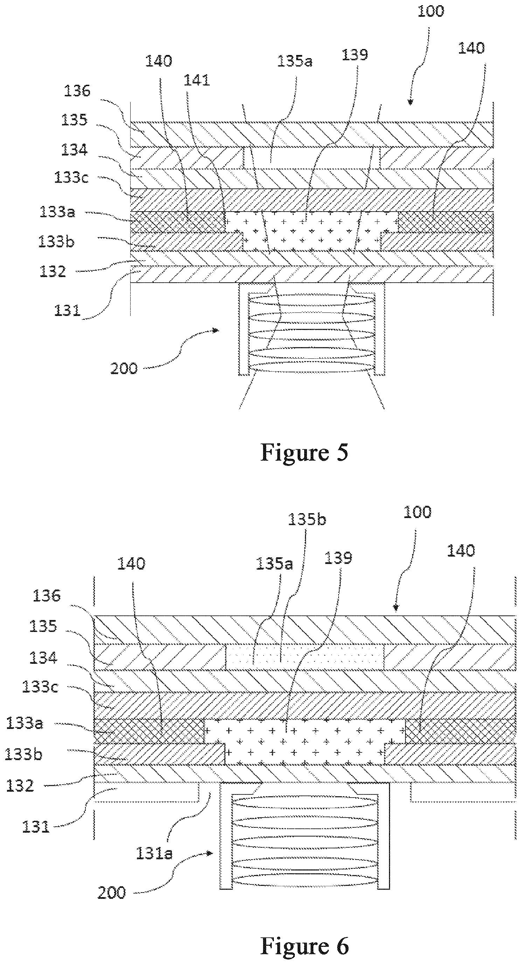

Figure 5 shows a schematic cross-sectional view of an under-screen camera assembly according to an example of the present application. Referring to Figure 5, the under-screen camera assembly includes an organic light-emitting diode display screen 100 and a camera module 200 located at a rear end of the organic light-emitting diode display screen 100. Wherein, the organic light-emitting diode display screen 100 includes a substrate 131, a buffer layer 132, a first electrode layer 133b, a pixel layer 133a, a second electrode layer 133c, a packaging layer 134, a polarizing layer 135, and a cover plate 136 from bottom to top. Wherein, the first electrode layer 133b, the pixel layer 133a, and the second electrode layer 133c may constitute a display layer 133. And, the pixel layer 133a may include a main display area 140 and a light-transmitting area 139. In a top view, the shape and positional relationship of the main display area 140 and the light-transmitting area 139 can refer to Figure 2. And, the main display area 140 corresponds to a non-under-screen camera area 110 in Figure 2, and the light-transmitting area 139 corresponds to the under-screen camera area 120 in Figure 2. In this example, the polarizing layer 135 has a polarizing layer through hole 135a and the polarizing layer through hole 135a is located directly above the light-transmitting area 139. A light-passing channel based on the polarizing layer through hole 135a and the light-transmitting area 139 can constitute the under-screen camera area 120. In this example, An aperture of the polarizing layer through hole 135a may be 1 mm to 2.5 mm. The packaging layer 134 covers the main display area 140 and the light-transmitting area 139. The polarizing layer 135 can be bound to the packaging layer 134 by optical glue (the optical glue between the polarizing layer 135 and the packaging layer is not shown in Figure 5). The optical glue can also be used for bonding between the cover plate 136 and the polarizing layer 135 (the optical glue between the cover plate 136 and the polarizing layer 135 is not shown in Figure 5). The main display area 140 includes a plurality of pixel light-emitting structures 138 arranged in an array (it sould be noted that the pixel light-emitting structure 138 is not shown in the main display area 140 in Figure 5, shape and position of the pixel light-emitting structure 138 can refer to Figure 4) and a pixel defining structure 137 filling gaps between the plurality of pixel light-emitting structures 138 (refer to Figure 4). In this example, each of the pixel light-emitting structures 138 includes a hole injection layer, a hole transport layer, an electron transport layer, an electron injection layer, and a light-emitting material layer located between the hole transport layer and the electron transport layer. Wherein, the hole injection layer and the hole transport layer can be referred to as the hole layer, and the electron transport layer and the electron injection layer can be referred to as the electron layer. In this example, the light-transmitting area 139 may not be provided with the pixel light-emitting structure 138, but may be formed by filling with the optical glue. An light transmittance of the optical glue can reach 99%, and it has excellent light transmittance. In another example, the light-transmitting area 139 is also not provided with the pixel light-emitting structure, but different from the previous example, the light-transmitting area 139 in this example is made of a filling material of the pixel defining structure 137, or in other words, the light-transmitting area 139 in this example can be regarded as an ultra-large pixel defining structure, which can be compatible with the existing OLED manufacturing process to the greatest extent, so as to facilitate large-scale mass production, and help improve yield and reduce costs. In addition, since the pixel defining structure can use a filling material with a relatively large light transmittance, the light-transmitting area 139 can meet requirement of the amount of light entering the under-screen camera module. A sidewall of the pixel defining structure 137 can be provided with a light blocking layer to better isolate each of the pixel light-emitting structures 138, and the filling material mentioned here is a filling material constituting a primary part of the pixel defining structure 137.

Further, the construction method of the light-transmitting area 139 of the present application is not limited to the above two examples. In theory, the light-transmitting area 139 is made of a material different from the main display area 140 (usually a light-transmitting material) or a light-transmitting structure (for example, a pixel light-emitting/defining structure with reduced pixel density), so that the light transmittance of the light-transmitting area 139 is greater than that of the main display area 140, and a light-transmitting area that is convenient for the under-screen camera module to receive external light can be obtained. In some examples of the present application, the light-transmitting area 139 of the pixel layer 133a may not be subjected to special processing. Since the polarizing layer 135 has the polarizing layer through hole 135a, and the pixel layer 133a of the OLED screen itself has a certain light transmittance, in some cases (for example, the imaging quality of the front camera module is not extremely demanding), the under-screen camera area can already meet the requirement of the amount of light entering the under-screen camera module, and at this time, the light-transmitting area 139 of the pixel layer 133a may not be subjected to special processing. In this way, the light-transmitting area 139 may have a pixel light-emitting structure 138, and its pixel size and spacing may be completely consistent with pixel size and spacing of the main display area 140, so as to provide a true full-screen display effect. Still referring to FIG. 5, in the above-mentioned example of the present application, the packaging layer 134 packages the pixel layer 133a by covering an upper surface of the main display area 140 and the light-transmitting area 139 (it should be noted that, here "covering" is not limited to direct coverage, and other functional layers, such as a second electrode layer 133c, can be added between the packaging layer 134 and the pixel layer 133a, and the packaging layer 134 can achieve coverage of the upper surface of the main display area 140 and the light-transmitting area 139 by covering the second electrode layer 133c). This packaging method eliminates the need to punch a through hole in the display layer 133 (or the pixel layer 133a), and an inner wall of the through hole of the display layer 133 (or the pixel layer 133a) may not use a sidewall packaging layer 134 (or called a packaging material layer) to package. That is, an interface 141 between the light-transmitting area 139 and the main display area 140 may not be provided with the packaging material layer. In other words, when the light-transmitting area 139 is made of a different material from the main display area 140, a side surface of the main display area 140 and a side surface of the light-transmitting area 139 of the pixel layer 133a are in direct contact, and the two have the common interface 141. When a structure of the light-transmitting area 139 is the same as that of the main display area 140, there may be no obvious interface 141 between the light-transmitting area 139 and the main display area 140 (that is, no packaging material may be added between the light-transmitting area 139 and the main display area 140, in particular, no packaging material for packaging a functional layer containing organic material is added between the light-transmitting area 139 and the main display area 140). In summary, herein, the meaning of not providing the packaging material layer (or not using the packaging material to separate) between the light-transmitting area 139 and the main display area 140 can be understood as: there is a common interface 141 between the light-transmitting area 139 and the main display area 140 or there is no interface 141 between the light-transmitting area 139 and the main display area 140. The absence of the interface 141 between the light-transmitting area 139 and the main display area 140 can be understood as: there is a natural transition between the light-transmitting area 139 and the main display area 140, or the light-transmitting area 139 and the main display area 140 are continuous. The packaging material here can be understood as: a sealing material used to isolate the functional layer from the outside to prevent an organic material in the functional layer from oxidizing and degrading. For example, the packaging layer 134 covering the upper surface of the light-transmitting area 139 and the main display area 140 is formed by using the packaging material.

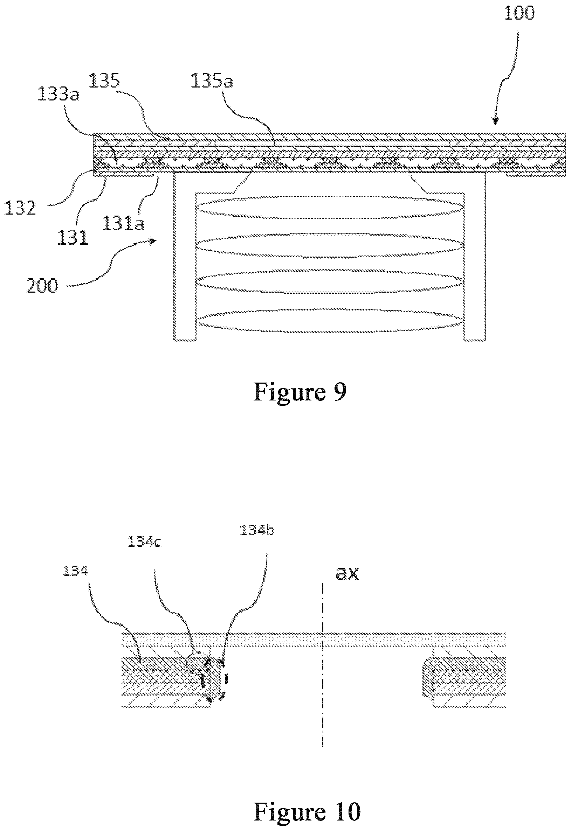

Based on the above analysis, it can be seen that since the light-transmitting area 139 and the main display area 140 may not be added with a material for packaging, the pixel light-emitting structure 138 of the display layer 133 can be fabricated at a position closer to a central axis (or an optical axis) of the through hole, thereby reducing a blank area (i.e., an area without pixel) visible to users (such as mobile phone users). On the contrary, Figure 10 shows a schematic cross-sectional view of a comparative example of an organic light-emitting diode display screen using a through hole screen scheme. In this comparative example, a through hole is punched in a display layer, and a sidewall of the through hole needs to cover a packaging layer 134b in order to avoid the oxidation of an organic material and cause product defects. In this way, due to the need to reserve space for the packaging layer 134b covering the sidewall of the through hole, a pixel light-emitting structure has to be arranged to a position further outside (that is, the side farther from the optical axis ax). Further, the packaging layer 134b attached to the sidewall of the through hole runs vertically and is located in the through hole. The process complexity of manufacturing the packaging layer 134b in the through hole is higher than the traditional process complexity of manufacturing the packaging layer 134 on the surface of the display layer (or a second electrode layer). This will cause thickness of the packaging layer 134b in the through hole to be difficult to control (for example, the packaging layer 134b in the through hole may have a problem of uneven thickness, and an edge area 134c of the packaging layer 134 on the surface close to the through hole may also have unevenness). In addition, using the solution of this comparative example, in the engineering practice of mass production, in order to ensure the successful packaging, it may be necessary to reserve a larger radial dimension for the packaging layer in the through hole (here the radial direction can be regarded as a direction perpendicular to the optical axis), this will cause the blank area (i.e., no pixel area) of the display layer to further increase. In the foregoing example of the present application, although the light-transmitting area 139 is constructed in the display layer 133, the light-transmitting area 139 and the main display area 140 still form a complete integrity, and they may have a continuous surface for fabricating the second electrode layer 133c and the packaging layer 134 on the surface. In other words, the light-transmitting area 139 and the main display area 140 can constuct a continuous surface that can be attached by the packaging layer 134, so that the packaging layer 134 is still made by a traditional process (that is, the packaging layer is directly made on an upper surface of the semi-finished OLED), namely it can achieve the effect of preventing the oxidation of the organic material. On one hand, this reduces the process difficulty of the "hole-dig screen", thereby improving the production efficiency and reducing the production cost of the under-screen camera module based on the "hole-dig screen"; on the other hand, it can ensure the amount of light entering the under-screen camera module, while it helps to reduce the size of the holes of the "hole-dig", thereby enhancing the user experience.

In the above-mentioned examples of the present application, the organic light-emitting diode display screens are not punched with through holes, and the light-passing channels of such display screens without through holes are analyzed as follows in combination with some specific data. Among the functional layers through which the light-passing channel passes, transmittance of the glass cover 136 usually exceeds 90%, transmittance of the optical glue is as high as 99%, and transmittance of the thin film packaging layer 134 also exceeds 90%, and transmittance of the second electrode layer 133c can reach 80%. In this way, by avoiding the opaque first electrode layer 133b and the low-transmittance polarizer layer 135, digging holes in a base material (the substrate 131), and selecting a buffer layer material with high transmittance (such as silicon oxide, aluminum oxide, aluminum nitride, silicon nitride, silicon oxynitride and other inorganic materials, as well as polyimide, polyester, acryl and other organic materials, the main portion of the buffer layer 132 can be arbitrarily stacked by inorganic materials and organic materials), overall transmittance of the light-passing channel of the display screen can exceed 67%, which meets a requirement of clear imaging, so that the front camera module becomes possible.

Further, in an example of the present application, the cover plate 136 may not be perforated, so as to achieve better protection and dust prevention. Since the transmittance of the cover plate can exceed 90%, the cover plate can still meet the imaging requirements of the under-screen module without perforating the cover plate.

Further, Figure 6 shows a schematic cross-sectional view of an under-screen camera assembly according to another example of the present application. Referring to FIG. 6, in the present example, in the organic light-emitting diode display screen 100, the polarizing layer through hole 135a is filled with the optical glue 135b. The regional structure and materials of this example can be completely the same as the example of Figure 5, and will not be repeated here.

Further, still referring to Figure 6, in an example of the present application, in the organic light-emitting diode display screen, the substrate 131 has a substrate through hole 131a corresponding to the light-transmitting area 139. Digging the substrate (or called the base layer or base material) of the display device can help increase the amount of light entering the under-screen camera module.

Further, still referring to Figure 6, in an example of the present application, in the organic light-emitting diode display screen, the main display area 140 and the light-transmitting area 139 of the pixel layer together form a continuous flat upper surface. The packaging layer packages the pixel layer by covering the continuous upper surface. In this way, in this example, there is no need to provide an packaging material between the main display area and the light-transmitting area to realize the packaging of the display layer, which reduces the process difficulty and also helps to reduce the aperture of the display blank area.

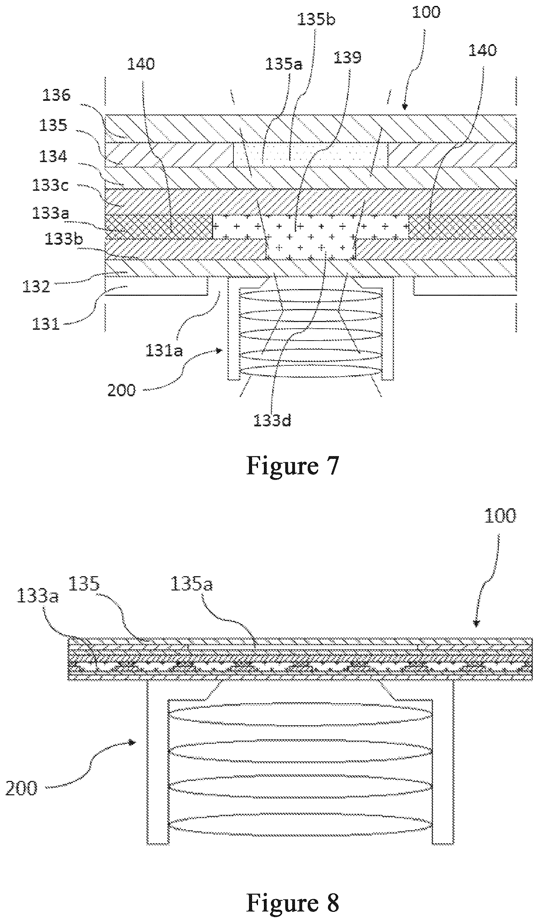

Further, Figure 7 shows a schematic cross-sectional view of an under-screen camera assembly according to yet another example of the present application. Referring to Figure 7, in the present example, in the organic light-emitting diode display screen 100, the display layer 133 includes a pixel layer 133a and a first electrode layer 133b and a second electrode layer 133c respectively located below and above the pixel layer 133a. A packaging layer 134 covers an upper surface of the second electrode layer 133c. The difference between this example and the example shown in Figure 6 is that the first electrode layer 133b located below constitutes a diaphragm (aperture diaphragm) of the camera module. The dotted line in

Figure 7 shows a light-passing channel used for imaging in this example. It can be seen from Figure 7 that a through hole 133d of the first electrode layer 133b functions as a diaphragm.

Further, still referring to Figure 7, in an example of the present application, the substrate 131 has a substrate through hole 131a corresponding to the light-transmitting area 139, and a top end of the camera module 200 extends into the substrate through hole 131a and bears against a bottom surface of the buffer layer 132. The top of the under-screen camera module directly bears against the buffer layer 132 of the display device, which can reduce the transmission distance of external light to the camera module, thereby further increasing the amount of light entering the under-screen camera module. This is because the light-passing channel is actually tapered, so under the premise that the size of the light through hole on the display surface (referring to the front surface) remains unchanged, the closer the top of the camera module is to the surface of display screen (referring to the front surface), the greater the amount of light received is. Conversely, under the premise of the same amount of light, the closer the top of the camera module is to the display surface (referring to the front surface), the more conducive to reducing the size of the light through hole (or called the aperture) on the surface of the display screen (referring to the front surface), thereby enhancing the user's visual experience.

Further, in an example of the present application, the first electrode layer is a cathode layer, and the cathode layer has a cathode layer through hole to form a light through hole of the diaphragm, and the thickness of the cathode layer reaches a thickness suitable for light shielding to form the light shielding portion of the diaphragm. In terms of specific implementation, the thickness of the first electrode can be increased to be sufficient to limit the size of the imaging light beam passing through the light-passing channel, and the first electrode can be made into a diaphragm. Of course, in another example, the diaphragm can also be formed by arranging an opaque material inside the first electrode of the light-passing channel.

Further, in an example of the present application, the first electrode layer has a first through hole to form an aperture of the diaphragm, and the first through hole is filled with the optical glue. By making the first electrode layer in the display device into a diaphragm, the height of the under-screen camera module (referring to the size in the direction of the optical axis) can be reduced, thereby helping to reduce the thickness of the terminal device (such as a mobile phone).

Further, Figure 8 shows a schematic cross-sectional view of an under-screen camera assembly of an example of the present application in which a light-transmitting area and a main display area adopt the same structure. Referring to Figure 8, in this example, the organic light-emitting diode display screen 100 includes: a substrate, a buffer layer, a first electrode layer, a pixel layer, a second electrode layer, a packaging layer, a polarizing layer 135 and a cover plate. The pixel layer includes a main display area and a light-transmitting area, the polarizing layer 135 has a polarizing layer through hole 135a, and a part of the pixel layer 133a directly below the polarizing layer through hole 135a forms the light-transmitting area, and the packaging layer packages the pixel layer by covering an upper surface of the main display area and the light-transmitting area. No packaging material is used to separate the main display area and the light-transmitting area. In this example, there is no interface between the light-transmitting area and the main display area. The absence of tge interface between the light-transmitting area and the main display area can be understood as: a natural transition is between the light-transmitting area and the main display area, or the light-transmitting area and the main display area are continuous. The camera module 200 is installed at a rear end of the light-transmitting area (that is, a rear end of the polarizing layer through hole 135a).

Further, Figure 9 shows a schematic cross-sectional view of an under-screen camera assembly of another example of the present application inwhich a light-transmitting area and a main display area adopt a same structure. The difference between this example and the example in Figure 8 is that the substrate 131 has a substrate through hole 131a, a part of a bottom surface of the buffer layer 132 is exposed outside the substrate 131, and a top surface of the camera module 200 bears against the bottom surface of the buffer layer 132. (refers to the part of the bottom surface of the buffer layer 132 that is exposed to the outside of the substrate 131).

Further, in an example of the present application, in the organic light-emitting diode display screen, the light-transmitting area may have a pixel light-emitting structure, and a pixel pitch of the light-transmitting area is greater than that of the main display area, so that a light transmittance of the light-transmitting area is greater than that of the main display area. In this example, by setting the pixel density of the light-transmitting area (sometimes referred to as PPI in the industry, and its full name is Pixels Per Inch) to be smaller than the pixel density of the non-under screen camera area 110, the light transmittance of the light-transmitting area (corresponding to the under-screen camera area 120 shown in Figure 1 and Figure 2) is improved. In this way, the screen can avoid the imaging light path of the camera module without punching a hole, so that the display screen can be kept intact. Moreover, since the light-emitting structure and the corresponding microcircuit can be retained, when the camera module is not used, the under-screen camera area 120 can perform image display. The under-screen camera area 120 and the non-under-screen camera area 110 can jointly form a complete picture, truly realizing a full-screen display effect. The under-screen camera assembly of this example is particularly suitable for use in smart phones, and the camera module in the under-screen camera assembly is particularly suitable for use as the front camera module of the smart phone.

Further, on the basis of the example inwhich the light-transmitting area has a pixel light-emitting structure, the under-screen camera assembly may further include: a first control unit, which is used to control both of the under-screen camera area and the non-under-screen camera area display images in the non-working state of the camera module; and in the working state of the camera module, to control the display function of the under-screen camera area to be turned off. In the area where the display function is turned off (such as the under-screen camera area), the light-emitting layer of each pixel does not emit light, so that when the module is shooting, there will be no stray light from the display screen that affects the image shooting. During shooting, all of the non-under-screen imaging area can display images; it is also possible to display no image in the surrounding area surrounding the under-screen camera area (that is, the light-emitting layer of the pixels in the surrounding area does not emit light), and the remaining part displays the image. For example, when the under-screen camera assembly is applied to a smart phone, when the smart phone calls the front camera, the first control unit can turn off the display function of the under-screen camera area on the screen (that is, the under-screen camera area is not lit), so that external light can pass through the under-screen camera area and be received by the front camera. Since many improvements in the under-screen camera area can increase its light transmittance, the amount of light entering the front camera can reach the standard for effective imaging. At the same time, the non-under-screen camera area can still work in order to display the picture taken by the front camera for better taking pictures (for example, when taking selfies, the non-under-screen camera area displays the face image) or shooting video (for example, during a video conference, the corresponding image is displayed by the non-under-screen camera area). In this example, the first control unit can be set in the operating system or application of the mobile phone (or other terminal device), or can be implemented as a part of the display driving circuit.

Further, on the basis of the example inwhich the light-transmitting area has a pixel light-emitting structure, the under-screen camera assembly may further include: a second control unit, which is used for compensating the brightness of the under-screen camera area when both of the under-screen camera area and the non-under-screen camera area display images. In this example, in order to increase the amount of light entering the camera module, the pixel density of the under-screen camera area (sometimes referred to as PPI in the industry, and its full name is Pixels Per Inch) is set to be smaller than that of the non-under-screen camera area. It should be noted that, in the present application, the lower pixel density of the under-screen camera area is set to increase the pixel pitch. Therefore, in the under-screen camera area, the light-emitting surface per unit area may be reduced, which may cause the brightness of the the under-screen camera area to be decreased (referring to the lower brightness of the under-screen camera area compared with the non-under-screen camera area). If the brightness of the under-screen camera area is not compensated, then in the full-screen display, although the position of the front camera module can display images, its brightness may be significantly lower, then in contrast with the surrounding non-under-screen camera area, this position (the position of the front camera module) may form a dark spot (that is, a block whose brightness is significantly lower than the surrounding area). Such dark spots may be easily noticed by users visually, thereby affecting user experience. Based on the above analysis, it can be seen that, using the second control unit to compensate the brightness of the under-screen camera area in this example can eliminate or suppress the aforementioned dark spots caused by the increase in the pixel pitch of the under-screen camera area. Here, the compensation for the brightness may be compensation at the software level, for example, adaptive adjustment at the operating system level or application level of the mobile phone (or other terminal device). For example, through software adjustment, the brightness of the under-screen camera area is increased, so as to be consistent with the surrounding non-under-screen camera area, thereby eliminating or suppressing dark spots in the under-screen camera area. In this way, the user can see a complete screen and the complete and continuous image displayed on the screen, and obtain an extremely shocking visual enjoyment. Of course, the brightness of the under-screen camera area can also be compensated in the display driving circuit. It should be noted that, in another example of the present application, the TFT (i.e., the thin film transistor switch under the light-emitting layer of each pixel) in the under-screen camera area can also be used to realize that the brightness per unit area of the under-screen camera area is equivalent to the brightness per unit area of the other area (that is, the non-under-screen camera area), so as to realize the compensation of the brightness of the under-screen camera area. That is, the second control unit can be implemented at the hardware level of the display screen.

Furthermore, it should be noted that since many improvements have been made to increase the transmittance of the under-screen camera area, in addition to the brightness, compared with the non-under-screen camera area, there may be other differences between the display effect. For example, due to many improvements to increase the transmittance of the under-screen camera area, other display parameters such as the contrast of the under-screen camera area may change, resulting in the formation of a certain boundary between the under-screen camera area and the non-under-screen camera area due to this change. If this kind of boundary is easy to be noticed by the human eye, it may also make people feel that the image displayed on the screen is incomplete and discontinuous, and the visual effect of the full screen may be compromised. Based on the above analysis, in an example of the present application, the under-screen camera assembly further includes a second control unit, which is used to compensate display parameters of the under-screen camera area when both of the under-screen camera area and the non-under-screen camera area display images, so that the displayed image transitions smoothly between the under-screen camera area and the non-under-screen camera area, so that the under-screen camera area and the non-under-screen camera area can form a complete and continuous picture, and there is no boundary between the under-screen camera area and the non-under-screen camera area in the picture that is easy to be noticed by the naked eye. Compensating the display parameters of the under-screen camera area may be compensation at the software level, such as adaptive adjustment at the operating system level or application level of a mobile phone (or other terminal device). Of course, the display driving circuit can also be used to compensate the display parameters of the under-screen camera area. Display parameters can include brightness and contrast.

Further, on the basis of the example inwhich the light-transmitting area has a pixel light-emitting structure, the pixel size of the under-screen camera area and the pixel size of the non-under-screen camera area may be the same. The pixel size here refers to the size of the light-emitting structure. Under this design, the under-screen camera area and the non-under-screen camera area can share many production processes and production equipment, which helps to improve production efficiency and increase yield. It should be noted that, in other examples of the present application, the pixel size of the under-screen camera area and the pixel size of the non-under-screen camera area may also be different. Reducing the pixel density of the under-screen camera area can help increase the spacing between pixels, thereby increasing the transmittance of the under-screen camera area.

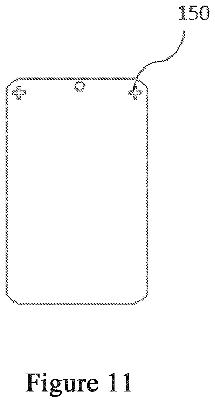

Further, Figure 11 shows a schematic diagram of a substrate of an OLED screen with a positioning mark. Referring to Figure 11, in an example of the present application, in order to facilitate the assembly of the under-screen camera assembly, at least two positioning marks 150 may be provided on the substrate of the OLED screen, and the positioning marks 150 are used for position identification during the assembly process of the OLED screen and the camera module to improve the assembly accuracy (for example, improve the alignment accuracy of the through-light hole). The positioning mark does not overlap with the projection of the camera module on the display screen, so that the camera module and the display screen can be adjusted in real time during assembly. For the camera module and the OLED screen, glue material can be set on the contact surface for bonding and fixing, or the camera module can be closely attached to the OLED screen and bonded by glue on the side, or two places (contact surface and side surface) can be bonded at the same time. The positioning mark can be an ink pattern, or it can be realized by laser marking, or it can be formed by grooving the substrate of the OLED screen, or it can be a special structure integrally formed with the substrate.

Further, in an example of the present application, a terminal device is also provided, which includes the under-screen camera assembly described in any of the foregoing examples. Wherein, the camera module may be used as a front camera module of the terminal device, and the organic light-emitting diode display screen may be used as a display panel on the front of the terminal device.

It should be noted that, the pixel density (PPI) herein is sometimes also referred to as display density.

The above description is only the preferred examples of the present application and the description of the applied technical principles. Those skilled in the art should understand that, the scope of the invention involved in the present application is not limited to the technical solution formed by the specific combination of the above technical features, and should also cover other technical solutions formed by any combination of the above technical features and its equivalent features without departing from the inventive concept, for example, a technical solution formed by mutually replacing the above-mentioned features and the technical features disclosed in the present application (but not limited to) and with similar functions.

## Claims

1. An organic light-emitting diode display screen, which **characterized by** comprising: a substrate, a buffer layer, a first electrode layer, a pixel layer, a second electrode layer, a packaging layer, a polarizing layer and a cover plate;
wherein the pixel layer includes a main display area and a light-transmitting area, and the polarizing layer has a polarizing layer through hole, and a part of the pixel layer located directly below the polarizing layer through hole forms the light-transmitting area, and the main display area and the light-transmitting area are not separated using a packaging material, and the packaging layer packages the pixel layer by covering upper surfaces of the main display area and the light-transmitting area.

2. The organic light-emitting diode display screen of claim 1, wherein an aperture of the polarizing layer through hole is 1 mm to 2.5 mm.

3. The organic light-emitting diode display screen of claim 1, wherein the main display area includes a plurality of pixel light-emitting structures arranged in an array and a pixel defining structure filling gaps between the plurality of pixel light-emitting structures, and the light-transmitting area is formed by filling a light-transmitting material or a light-transmitting structure, so that a light transmittance of the light-transmitting area is greater than that of the main display area.

4. The organic light-emitting diode display screen of claim 3, wherein the polarizing layer is bonded to the packaging layer by an optical glue.

5. The organic light-emitting diode display screen of claim 1, wherein the polarizing layer through hole is filled with an optical glue.

6. The organic light-emitting diode display screen of claim 1, wherein the main display area and the light-transmitting area together form a continuous upper surface, and the packaging layer packages the pixel layer by covering the continuous upper surface.

7. The organic light-emitting diode display screen of claim 1, wherein the main display area includes a plurality of pixel light-emitting structures arranged in an array and a pixel defining structure filling gaps between the plurality of pixel light-emitting structures.

8. The organic light-emitting diode display screen of claim 7, wherein each of the pixel light-emitting structures includes a hole layer, an electron layer, and a light-emitting material layer located between the hole layer and the electron layer, and the hole layer includes a hole injection layer and a hole transport layer, and the electron layer includes an electron transport layer and an electron injection layer.

9. The organic light-emitting diode display screen of claim 1, wherein the substrate has a substrate through hole corresponding to the light-transmitting area.

10. The organic light-emitting diode display screen of claim 1, wherein the substrate is provided with a positioning mark, and the positioning mark is used to align the camera module to be assembled with the through hole during the assembly process.

11. The organic light-emitting diode display screen of claim 1, wherein the light-transmitting area is formed by filling with an optical glue.

12. The organic light-emitting diode display screen of claim 6, wherein a manufacturing material of the light-transmitting area is same as a filling material of the pixel defining structure, and the manufacturing material is a light-transmitting material.

13. The organic light-emitting diode display screen of claim 1, wherein the light-transmitting area has a pixel light-emitting structure, and a pixel pitch of the light-transmitting area is greater than a pixel pitch of the main display area, so that a light transmittance of the light-transmitting area is greater than that of the main display area.

14. An under-screen camera assembly, which **characterized by** comprising:
the organic light-emitting diode display screen of claims 1-13; and
a camera module, wherein an optical axis of the camera module is perpendicular to a surface of the organic light-emitting diode display screen, and the camera module is located at a rear end of the under-screen camera area.

15. The under-screen camera assembly of claim 14, wherein the first electrode layer and the second electrode layer are respectively located below and above the pixel layer, and the first electrode layer constitutes a diaphragm of the camera module.

16. The under-screen camera assembly of claim 15, wherein the packaging layer covers an upper surface of the second electrode layer.

17. The under-screen camera assembly of claim 14, wherein the substrate has a substrate through hole corresponding to the light-transmitting area, and a top end of the camera module extends into the substrate through hole and bears against a bottom surface of the buffer layer.

18. The under-screen camera assembly of claim 15, wherein the first electrode layer is a cathode layer, and the cathode layer has a cathode layer through hole to form an aperture of the diaphragm, and a thickness of the cathode layer achieves a thickness suitable for light shielding to form a light shielding portion of the diaphragm.

19. The under-screen camera assembly of claim 15, wherein the first electrode layer has a first through hole to form an aperture of the diaphragm, and the first through hole is filled with the optical glue.

20. A terminal device, which **characterized by** comrprising the under-screen camera assembly of any one of claims 14-19.

21. The terminal device of claim 20, wherein the camera module is used as a front camera module of the terminal device, and the organic light-emitting diode display screen is used as a display panel on the front of the terminal device.
